Europäisches Patentamt

European Patent Office

Office européen des brevets

(19)

(11) **EP 0 634 799 B1**

(12) **EUROPÄISCHE PATENTSCHRIFT**

(45) Veröffentlichungstag und Bekanntmachung des Hinweises auf die Patenterteilung:
**24.11.1999 Patentblatt 1999/47**

(51) Int Cl.[6]: **H01L 29/864**

(21) Anmeldenummer: **94108692.8**

(22) Anmeldetag: **07.06.1994**

(54) **Laufzeit-Diode**

Transit time diode

Diode à temps de transit

(84) Benannte Vertragsstaaten:
**DE FR GB IT NL**

(30) Priorität: **09.06.1993 DE 4319211**

(43) Veröffentlichungstag der Anmeldung:
**18.01.1995 Patentblatt 1995/03**

(73) Patentinhaber: **DaimlerChrysler AG**
**70567 Stuttgart (DE)**

(72) Erfinder:
• **Luy, Johann-Friedrich, Dr.-Ing.**
**D-89075 Ulm (DE)**
• **Jorke, Helmut, Dipl.-Phys.**
**D-89547 Gerstetten (DE)**

(56) Entgegenhaltungen:
**FR-A- 2 321 771      US-A- 3 356 866**
**US-A- 3 822 153**

• **RADIOELECTRONICS AND COMMUNICATIONS SYSTEMS, Bd.24, Nr.7, 1981 Seiten 62 - 65 G.P. PAVLOV 'The optimum doping profile of a BARITT diode'**
• **PROCEEDINGS OF THE IEEE, Bd.63, Nr.11, November 1975, NEW YORK US Seiten 1620 - 1621 O. EKNOYAN ET AL. 'Improved efficiency microwave BARITT oscillators by delayed injection'**
• **ELECTRONICS LETTERS, Bd.24, Nr.22, 27. Oktober 1988, ENAGE GB Seiten 1386 - 1387 J.F. LUY ET AL. 'Si/SiGe heterostructure MITATT diode'**

## Beschreibung

Die Erfindung betrifft eine Laufzeit-Diode mit Doppeldrift-Struktur nach dem Oberbegriff des Patentanspruchs 1.

Laufzeitdioden werden in der Hochfrequenztechnik zur Schwingungserzeugung oder als Verstärker verwendet. Gebräuchliche Formen sind insbesondere IMPATT-Dioden, TUNNETT-Dioden und BARITT-Dioden.

Die Funktion dieser Bauelemente beruht auf der Wirkung der Laufzeitverzögerung, die die Ladungsträger beim Durchlaufen des Halbleitergebiets erfahren, und die unter bestimmten Bedingungen zu einem negativen dynamischen Widerstand führt.

Die IMPATT-Diode ist eine sogenannte Lawinenlaufzeitdiode mit einem in Sperrichtung vorgespannten gleichrichtenden Kontakt. Die hohe Feldstärke im Bereich der Sperrzone beschleunigt die Ladungsträger derart, daß weitere Ladungsträger durch Stoßionisation lawinenartig erzeugt werden. Bei der Ladungsträgererzeugung sind sowohl Elektronen als auch Defektelektronen beteiligt, wogegen für den Laufzeiteffekt nur ein Ladungsträgertyp in die Driftzone injiziert wird.

IMPATT-Dioden weisen den Nachteil auf, daß ihr Rauschmaß verhältnismäßig hoch liegt.

Bei TUNNETT-Dioden erfolgt die Erzeugung von Ladungsträgerpaaren und die Ladungsträgerinjektion durch Interbandtunneln, Lawinenmultiplikation spielt eine untergeordnete Rolle. TUNNETT-Dioden zeigen ein geringeres Rauschmaß als IMPATT-Dioden. TUNNETT-Dioden sind beispielsweise beschrieben in der DE 20 61 689 B2 und der US-H 29.

Ebenfalls günstige Rauscheigenschaften zeigen BARITT-Dioden. S. Luryi und R.F. Kazarinov beschreiben in Solid-State Electronics, Vol. 25, No. 9, S. 943-945 die Funktionsweise von BARITT-Dioden. Der Aufbau entspricht einer npn- oder einer pnp-Diode. Die zentrale p- bzw. n-leitende Zone ist an Ladungsträgern verarmt, was zu einer Potentialbarriere führt, über die Ladungsträger durch thermionische Emission in den Driftbereich injiziert werden. Durch eine $\delta$-Dotierung der ansonsten undotierten Barriereschicht können bei sehr hohen Arbeitsfrequenzen (> 40 GHz) bessere Leistungen erzielt werden. Bei solchen BARITT-Dioden tritt nur ein Ladungsträgertyp auf.

Für IMPATT-Dioden ist es bekannt, daß zwei komplementäre Diodenstrukturen in einem Bauelement vereint werden in der Weise, daß eine gemeinsame Lawinenmultiplikations-Generationszone zur Ladungsträgererzeugung und Injektion in getrennte Driftzonen benutzt wird. Das Dotierprofil solcher Doppeldrift-Dioden entspricht der Reihenschaltung zweier komplementärer Einzeldrift-Dioden und führt vorteilhafterweise zu einer Erhöhung des Impedanzniveaus, wogegen der Nachteil des hohen Rauschmaßes auch für diese Diodenstruktur gilt. Verschiedene Ausführungen solcher Doppeldrift-IMPATT-Dioden sind bekannt. T. Misawa beschreibt in der US-A-3,356,866 unter anderem die Herstellung einer Doppeldrift-Diode mit p-i-p-i-n-i-n-Dotierungsprofil mittels Epitaxieverfahren. B. Collins et al. beschreiben in der US-A-3,822,153 den Aufbau eines p+-i-p-i-n-i-n+-Dotierungsprofils mittels Ionenimplantation. Die Ausgestaltung der Injektions- und Driftzonen einer IMPATT-Diode mit unterschiedlichen Materialien wird in US-A-4,857,972 von H. Jorke et al. beschrieben.

Der Erfindung liegt die Aufgabe zugrunde, eine Laufzeit-Diode für sehr hohe Frequenzen anzugeben, welche vorteilhafte Rausch- und Impedanzeigenschaften zeigt.

Die Erfindung ist im Patentanspruch 1 beschrieben. Die Unteransprüche enthalten vorteilhafte Ausgestaltungen und Weiterbildungen der Erfindung.

Die erfindungsgemäße Diodenstruktur besitzt den Vorteil, daß durch Beteiligung von Ladungstragern beiderlei Typs in getrennten Laufzeitbereichen ein höheres Impedanzniveau bei guten Rauscheigenschaften erreicht wird.

Wesentlich an der Erfindung ist die Verbindung komplementärer BARITT-Diodenstrukturen mit einer bei solchen Strukturen sonst nicht vorhandenen Generationszone für Ladungsträger beiderlei Typs. Die Erzeugung der Ladungsträger kann insbesondere mittels Tunneleffekts oder Lawinenmultiplikation erfolgen. Für die Erzeugung von Ladungsträgern über Lawinenmultiplikation ist die Schichtdicke der Generationzone in an sich bekannter Weise so dick zu wählen, daß ausreichende Stoßionisation stattfindet. Bei der Ladungsträgererzeugung mittels Tunneleffekt ist hingegen die Schichtdicke der Generationzone sehr gering und die Feldstärke so hoch zu wählen, daß Interbandtunneln möglich ist.

Die in der Generationszone erzeugten Ladungsträger beiderlei Typs relaxieren getrennt in die sich an die Generationszone anschließenden Energieminima, die durch $\delta$n- bzw. $\delta$p-dotierte, die undotierte Generationszone einschließende Schichten als Potentialtöpfe gebildet sind. Von diesen Energieminima erfolgt in für die Einfachdrift-BARITT-Dioden an sich bekannter Weise eine Ladungsträgerinjektion mittels thermischer Emission über eine Barriere. Das Hochfrequenzverhalten ist durch die thermionische Emission über die Barriere bestimmt, wogegen der Mechanismus der Ladungsträgererzeugung durch die Relaxation in die Energieminima hierfür nachrangig ist. Dies ermöglicht auch den Einsatz der Lawinenmultiplikation zur Ladungsträgererzeugung, ohne daß deren sonst nachteiliges Rauschmaß in Xauf genommen werden muß.

Die Erfindung ist nachfolgend anhand von bevorzugten Ausführungsbeispielen unter Bezugnahme auf die Abbildungen noch eingehend veranschaulicht.

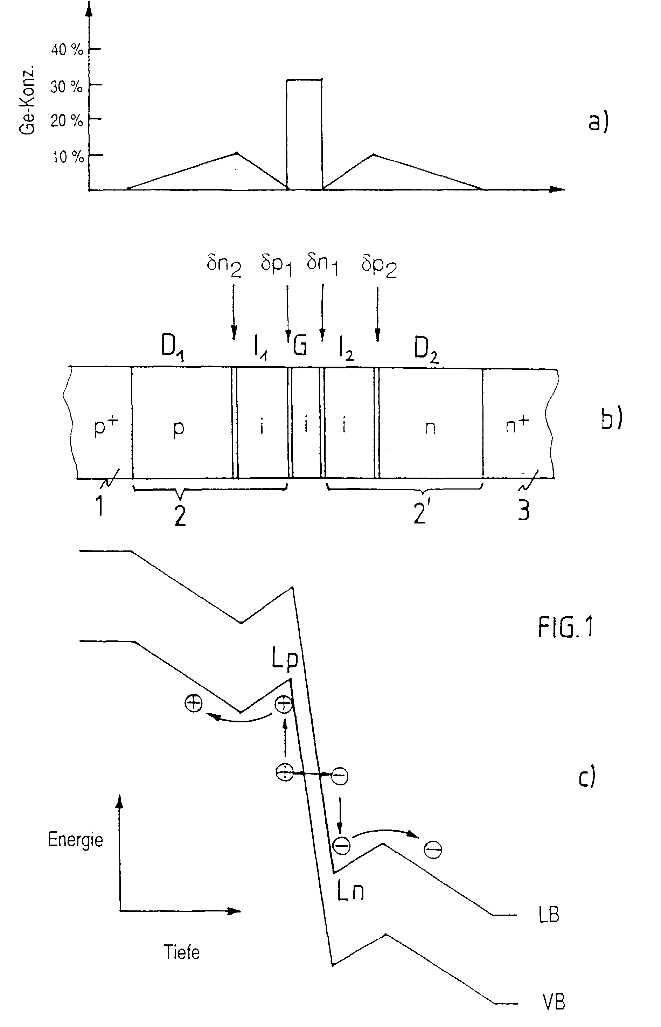

Durch Anlegen einer äußeren Spannung an die erfindungsgemäße Doppeldriftstruktur entsteht zwischen dem inneren $\delta$-Dotierelement $\delta$n$_1$, $\delta$p$_1$ in der Generationszone G ein hohes elektrisches Feld. Über Lawinenmultiplikation oder wie in FIG. 1c skizziert durch Interbandtunneln werden Ladungsträger beiderlei Typs gebildet.

Diese Ladungsträger relaxieren in die Energieminima der Potentialtöpfe Lp im Valenzband VB bzw. Ln im Leitungsband LB, die durch die $\delta p_1$- und $\delta n_1$-Dotierebenen gebildet werden (Fig. 1c).

Die Generationszone G ist in der Mitte der Diodenstruktur angeordnet, beiderseits davon liegen die Injektionszonen $I_1$, $I_2$ und die Driftzonen $D_1$ und $D_2$.

Nach der Ladungsträger-Relaxation werden die Ladungsträger, die jeweils ein zweidimensionales Ladungsträgergas an den Dotierebenen $\delta n_1$ und $\delta p_1$ bilden, thermionisch über die $\delta p_2$- und $\delta n_2$-dotierten Barrieren wie bei einer planar dotierten Einfachdrift-BARITT-Diode emittiert und gelangen dann in die Driftzonen $D_1$, $D_2$.

Im Gleichgewicht, das sich innerhalb der Relaxationszeit einstellt, nehmen die Feldstärke in G sowie die durch $\delta n_2$ und $\delta p_2$ gebildeten Barrieren Werte an, für die Gleichheit von Elektronen (bzw. Löcher)-Tunnelgenerationsstrom und Elektronen (Löcher)-Emissionsstrom gilt.

In Figur 1a, b ist die Diodenstruktur und der Ge-Gehalt der Si-Schichten schematisch dargestellt aus denen die Doppeldrift-BARITT-Diode beispielsweise hergestellt werden kann.

FIG. 1c zeigt das Energie-Band-Diagramm der beispielhaften Diodenstruktur.

Gemäß Fig.1b ist auf einem $p^+$-dotierten Si-Substrat 1 mit einer Ladungsträgerkonzentration von etwa $10^{20}$cm$^{-3}$ eine undotierte Si- oder SiGe-Schicht 2 aufgewachsen. Im Falle von SiGe als Halbleitermaterial wird die SiGe-Schicht pseudomorph auf die Si-Schicht 1 aufgewachsen. Bei einer Schichtdicke von ca. 750nm kann für ein pseudomorphes Wachstum der Ge-Gehalt der $Si_{1-x}Ge_x$-Schicht etwa $x = 0,1$ betragen. Die Schicht 2 enthält eine $\delta n_2$-dotierte Ebene mit einer Flächendotierung von etwa $1,5 \cdot 10^{12}$cm$^{-2}$. Als Dotiermaterial eignet sich z.B. Sb. Durch die $\delta$-Dotierung wird die Schicht 2 in eine Injektionszone $I_1$ und eine Driftzone $D_1$ eingeteilt. Die Injektionszone $I_1$ besitzt im vorliegenden Beispiel eine Länge $L_1 = 30$nm und die Driftzone $D_1$ eine Länge $L_2 = 750$nm. Die Driftzone $D_1$ kann auch gering p-dotiert sein mit einer Ladungsträgerkonzentration von ca. $3 \times 10^{16}$cm$^{-3}$.

An die Injektionszone $I_1$ schließt die Generationszone G an. Die Generationszone G ist beidseitig planar $\delta$-dotiert. Zwischen Injektionszone $I_1$ und Generationszone G ist eine $\delta p_1$-Dotierung eingebracht und zwischen G und der zweiten Injektionszone $I_2$ eine $\delta n_1$-Dotierung. Die Flächendotierung der $\delta p_1$-Ebene beträgt z.B. $5 \cdot 10^{13}$ B/cm$^2$ und der $\delta n_1$-Ebene $5 \cdot 10^{13}$ Sb/cm$^2$. Die Generationszone G hat eine Schichtdicke von z.B. 10nm und besteht z.B. aus undotiertem Si oder SiGe. Der Ge-Gehalt der $Si_{1-x}Ge_x$-Schicht kann bei einer Schichtdicke von 10nm etwa $x = 0,5$ betragen, um ein pseudomorphes Wachstum zu gewährleisten.

An die $\delta n_1$-Dotierung der Generationszonen G schließt eine Schicht 2' an, die eine weitere Injektionszone $I_2$, eine $\delta p_2$-Dotierung und eine Driftzone $D_2$ enthält. Das Halbleitermaterial und die Dimensionierungen der Schicht 2' entsprechen der Schicht 2. Die Driftzone $D_2$ ist entweder undotiert oder gering n-dotiert mit einer Ladungsträgerkonzentration von ca. $3 \times 10^{16}$cm$^{-3}$.

Die $\delta p_2$-Barriere besitzt eine Flächendotierung von z.B. $1,5 \cdot 10^{12}$B/cm$^2$.

Anschließend an die Driftzone $D_2$ ist eine $n^+$-Kontaktschicht 3 angebracht mit einer Schichtdicke von ca. 100nm und einer Ladungsträgerkonzentration von $10^{20}$ Sb/cm$^3$.

Die Ausgestaltung der erfindungsgemäßen Doppeldrift-BARITT-Diode mit dotierten SiGe-Driftzonen $D_1$, $D_2$ hat den Vorteil, daß die Driftgeschwindigkeit erhöht wird. Dieser Effekt ist z.B. in der DE 42 35 265 A1 beschrieben.

Die SiGe-Schichten 2, 2' besitzen außerdem einen Ge-Gehalt x, der von der Schicht 1 bzw. 3 bis zu den $\delta$-Dotierungen $\delta n_2$ bzw. $\delta p_2$ auf $x = 0,1$ kontinuierlich zunimmt und von den $\delta$-Dotierebenen $\delta n_2$, $\delta p_2$ bis zu den $\delta$-Dotierebenen $\delta p_1$ bzw. $\delta n_1$ wieder auf $x = o$ abnimmt (FIG.1a).

Gemäß einer anderen Ausführungsform ist anstelle der i($I_2$)-$\delta p_2$-i($D_2$)-Schichtenfolge eine p-dotierte Schicht und anstelle der i($I_1$)-$\delta n_2$-i($D_1$)-Schichtenfolge eine n-dotierte Schicht (jeweils z.B. $10^{16}$cm$^{-3}$) vorgesehen. Daraus resultiert eine Schichtenfolge $p^+$-n-$\delta p_1$-i (G)-$\delta n_1$-p-$n^+$ mit einem stärker gerundeten Bandverlauf der Barriere ohne das ausgeprägte Maximum der Struktur mit den Dotierebenen $\delta n_2$, $\delta p_2$.

Mit einer Doppeldrift-BARITT-Diode gemäß dem Ausführungsbeispiel erhält man bei einer Betriebsspannung von 10V und Strömen von 100 - 200 mA für Arbeitsfrequenzen von 70 - 100 GHz Leistungen von ca. 50mW.

Die Erfindung ist nicht auf die angegebenen Ausführungsbeispiele beschränkt, sondern es können sowohl andere Halbleitermaterialien z.B. III/V-Halbleiterverbindungen verwendet als auch die Ladungsträgerstruktur invertiert werden.

Desweiteren kann die Diode mit anderen Dotierungen sowie Dimensionierung hergestellt werden.

Als Herstellungsverfahren für die erfindungsgemäße Doppeldrift-BARITT-Diode eignet sich insbesondere die Molekularstrahl-Epitaxie.

**Patentansprüche**

1. Laufzeit-Diode in Doppeldrift-Struktur mit einer zentralen Generationszone (G) und zwei sich daran anschließenden komplementären Schichtstrukturen, dadurch gekennzeichnet, daß die Schichtstrukturen jeweils für den betreffenden Ladungsträgertyp ein an die Generationszone (G) anschließendes Energieminimum und eine BARITT-Diodenstruktur mit einer Barriere aufweisen, und daß das an die Generationszone anschließende Energieminimum durch die Generationszone einschließende δ-dotierte Schichten ($\delta p_1$, $\delta n_1$) gebildet ist.

2. Diode nach Anspruch 1, dadurch gekennzeichnet, daß in der Generationszone Ladungsträger durch Lawinenmultiplikation erzeugt werden.

3. Diode nach Anspruch 1, dadurch gekennzeichnet, daß in der Generationszone Ladungsträger durch Interbandtunneln erzeugt werden.

4. Diode nach einem der Ansprüche 1 bis 3, dadurch gekennzeichnet, daß die BARITT-Diodenstruktur eine Schichtenfolge aus einer Injektionszonenschicht ($I_1$, $I_2$), einer δ-dotierten Schicht ($\delta n_2$, $\delta p_2$) und einer Driftzonenschicht ($D_1$, $D_2$) besteht.

5. Diode nach Anspruch 4, gekennzeichnet durch eine Schichtenfolge $p^+$-i($D_1$)-$\delta n_2$-i($I_1$)-$\delta p_1$-i(G)-$\delta n_1$-i($I_2$)-$\delta p_2$-i($D_2$)-$n^+$ wobei G die Generationszone, $I_1$,$I_2$ die Injektionszonen und $D_1$, $D_2$ die Driftzonen der Diode sind.

6. Diode nach einem der Ansprüche 1 bis 3, dadurch gekennzeichnet, daß die BARITT-Diodenstruktur eine einheitlich dotierte Barrierenschicht enthält.

7. Diode nach einem der Ansprüche 1 bis 6, dadurch gekennzeichnet, daß eine oder mehrere Schichten aus pseudomorph auf Si gewachsenem SiGe bestehen.

8. Diode nach einem der vorhergehenden Ansprüche, dadurch gekennzeichnet, daß die BARITT-Diodenstrukturen pseudomorph gewachsenes SiGe mit veränderlichem und im Bereich des Maximums der Energiebarriere maximalen Ge-Gehalt aufweisen.

## Claims

1. Transit time diode in double-drift structure with a central generation zone (G) and two complementary layer structures adjoining thereat, characterised in that the layer structures each have for the relevant charge carrier type an energy minimum adjoining the generation zone (G) and a BARITT diode structure with a barrier, and that the energy minimum adjoining the generation zone is formed by 6 doped layers ($\delta p_1$, $\delta n_1$) including the generation zone.

2. Diode according to claim 1, characterised in that charge carriers are produced in the generation zone by cumulative multiplication.

3. Diode according to claim 1, characterised in that charge carriers are produced in the generation zone by interband tunnelling.

4. Diode according to one of claims 1 to 3, characterised in that the BARITT diode structure consists of a layer sequence of an injection zone layer ($I_1$, $I_2$), a δ doped layer ($\delta n_2$, $\delta p_2$) and a drift zone layer ($D_1$, $D_2$).

5. Diode according to claim 4, characterised by a layer sequence

$$p^+\text{-i}(D_1)\text{-}\delta n_2\text{-i}(I_1)\text{-}\delta p_1\text{-i}(G)\text{-}\delta n_1\text{-i}(I_2)\text{-}\delta p_2\text{-i}(D_2)\text{-}n^+$$

where G is the generation zone, $I_1$, $I_2$ are the injection zones and $D_1$, $D_2$ are the drift zones of the diode.

6. Diode according to one of claims 1 to 3, characterised in that the BARITT diode structure contains a homogeneously doped barrier layer.

7. Diode according to one of claims 1 to 6, characterised in that one or more layers consist of SiGe pseudomorphically grown on Si.

8. Diode according to one of the preceding claims, characterised in that the BARITT diode structures comprise pseudomorphically grown SiGe with variable Ge content at a maximum in the region of the maximum of the energy barrier.

## Revendications

1. Diode à temps de transit possédant une structure à double migration comprenant une zone centrale de génération (G) et deux structures à couches complémentaires se raccordant à cette zone, caractérisée en ce que les structures à couches comportent chacune, pour le type considéré de porteurs de charges, un minimum d'énergie adjacent à la zone de génération (G) et une structure de diodes BARITT comportant une barrière, et que le minimum d'énergie, qui jouxte la zone de génération, est formé par les couches ($\delta p_1$, $\delta n_1$) dopées par un dopage δ et enserrant la zone de génération.

2. Diode selon la revendication 1, caractérisée en ce que des porteurs de charges sont produits dans la zone de génération, par multiplication par avalanche.

3. Diode selon la revendication 1, caractérisée en ce que les porteurs de charges sont produits dans la zone de génération par effet tunnel entre bandes.

4. Diode selon l'une des revendications 1 à 3, caractérisée en ce que la structure de diode BARITT est constituée par une succession de couches comprenant une couche de zones d'injection ($I_1$, $I_2$), une couche ($\delta n_2$, $\delta p_2$) dopée avec un dopage $\delta$, et une couche à zones de migration ($D_1$, $D_2$).

5. Diode selon la revendication 4, caractérisée par une succession de couches

$$p^+\text{-}i(D_1)\text{-}\delta n_2\text{-}i(I_1)\text{-}\delta p_1\text{-}i(G)\text{-}\delta n_1\text{-}i(I_2)\text{-}\delta p_2\text{-}i(D_2)\text{-}n^+$$

G désignant la zone de génération, $I_1$, $I_2$ les zones d'injection et $D_1$, $D_2$ les zones de migration de la diode.

6. Diode selon l'une des revendications 1 à 3, caractérisée en ce que la structure de diode BARITT contient une couche formant barrière à dopage uniforme.

7. Diode selon l'une des revendications 1 à 6, caractérisée en ce qu'une ou plusieurs couches sont constituées par du SiGe formé au moyen d'une croissance pseudomorphe sur du Si.

8. Diode selon l'une des revendications précédentes, caractérisée en ce que les structures de diodes BARITT comportent du SiGe formé par croissance pseudomorphe avec une teneur en Ge variable, dont le maximum se situe dans la zone du maximum de la barrière d'énergie.

a)

$\delta n_2$  $\delta p_1$  $\delta n_1$  $\delta p_2$

$D_1$  $I_1$  'G  $I_2$  $D_2$

$p^+$  p  i  i  i  n  $n^+$

b)

1  2  2'  3

FIG.1

Lp

c)

Energie

Tiefe

Ln

LB

VB